# FASCICULE DE BREVET EUROPEEN

(11) **EP 3 147 952 B1**
(45) Date de publication et mention de la délivrance du brevet: **28.11.2018**
(21) Numéro de dépôt: 16189831.7
(22) Date de dépôt: 21.09.2016
(51) Int. Cl.: H01L 31/02, H02S 40/34, B64G 1/44

(54) **GENERATEUR SOLAIRE FLEXIBLE MUNI D'UNE PROTECTION ELECTRIQUE CONTRE DES IMPACTS D'OBJETS CELESTES, ENGIN SPATIAL ET SATELLITE COMPORTANT AU MOINS UN TEL GENERATEUR SOLAIRE**
FLEXIBLER SOLARGENERATOR, DER MIT EINEM ELEKTRISCHEN SCHUTZ GEGEN EINSCHLÄGE VON HIMMELSKÖRPERN AUSGESTATTET IST, RAUMSCHIFF UND SATELLIT, DIE MINDESTENS EINEN SOLCHEN SOLARGENERATOR UMFASSEN
FLEXIBLE SOLAR GENERATOR PROVIDED WITH ELECTRICAL PROTECTION AGAINST IMPACTS OF CELESTIAL OBJECTS, SPACECRAFT AND SATELLITE COMPRISING AT LEAST ONE SUCH SOLAR GENERATOR

(30) Priorité: 25.09.2015 FR 1501980
(43) Date de publication de la demande: 29.03.2017
(73) Titulaire: Thales, 92400 Courbevoie (FR)
(72) Inventeur: BOULANGER, Bernard, 83600 Frejus (FR); VOIRIN, Jean-Noël, 06550 La Roquette sur Siagne (FR); D'ABRIGEON, Laurent, 83440 Callian (FR)
(74) Mandataire: Esselin, Sophie

(56) Documents cités:
- EP-A2- 0 938 141
- CN-A- 103 972 314
- US-A1- 2006 225 779
- US-A1- 2009 301 544
- MENGU CHO: "Failure mechanisms and protection methods of spacecraft power system", ELECTRICAL INSULATING MATERIALS, 2005. (ISEIM 2005). PROCEEDINGS OF 20 05 INTERNATIONAL SYMPOSIUM ON KITAKYUSHU, JAPAN 5-9 JUNE 2005, PISCATAWAY, NJ, USA,IEEE, US, vol. 1, 5 juin 2005 (2005-06-05), pages 45-48Vol.1, XP010827647, ISBN: 978-4-88686-063-7

## Description

La présente invention concerne un générateur solaire flexible muni d'une protection électrique contre des impacts d'objets célestes, un engin spatial et un satellite comportant au moins un tel générateur solaire. Elle s'applique à tout générateur solaire comportant un support flexible et plus particulièrement au domaine des applications spatiales dans lesquelles des générateurs solaires sont montés sur des engins spatiaux ou sur des satellites en orbite.

Les générateurs solaires montés sur des engins spatiaux, par exemple des satellites, comportent en général, un réseau de cellules solaires connectées électriquement entre elles et au satellite, les cellules solaires, recouvrant la surface de panneaux de support, étant aptes à transformer l'énergie solaire en énergie électrique transmise aux équipements électriques du satellite. Les cellules solaires peuvent être aménagées sur plusieurs panneaux solaires rigides ou sur un support flexible, par exemple une membrane flexible, dont l'épaisseur est beaucoup plus fine que l'épaisseur des panneaux solaires rigides. En effet, un générateur solaire flexible est généralement constitué d'un support flexible comportant une face avant sur laquelle sont montées des cellules solaires, chaque cellule solaire étant munie d'une fenêtre de protection en verre (en anglais : coverglass), une face arrière sur laquelle sont aménagés des conducteurs électriques et au moins une couche de matériau isolant, par exemple du Kapton, situé entre les cellules solaires et les conducteurs électriques.

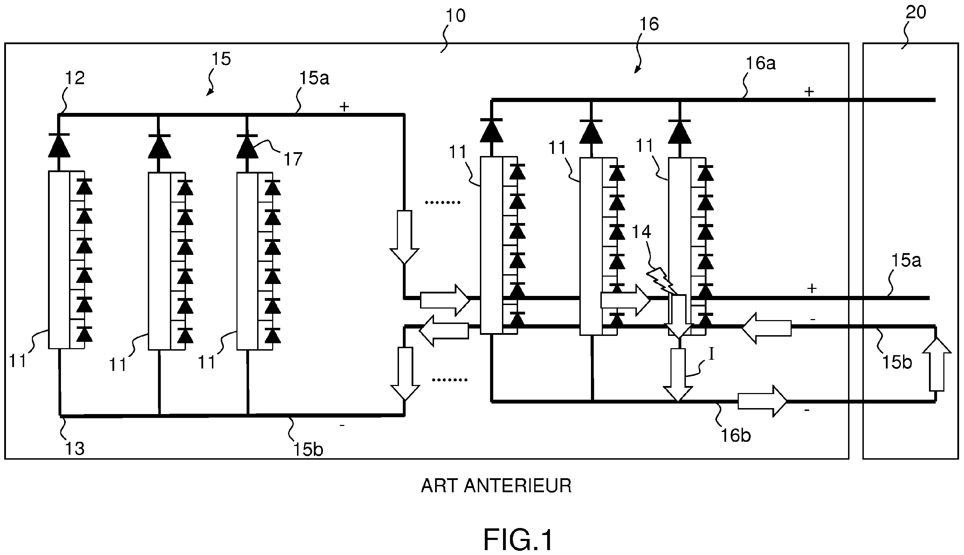

Comme représenté sur le schéma électrique de la figure 1, les cellules solaires aménagées sur le support flexible 10 et situées sur une même ligne du générateur solaire sont généralement connectées électriquement en série, chaque ligne 11 (en anglais : string) comportant deux extrémités 12, 13 à polarité respectivement positive et négative. Les extrémités 12, 13 à polarité positive, respectivement négative, de plusieurs lignes sont ensuite connectées électriquement entre elles pour former plusieurs sections 15, 16 différentes, chaque section étant constituée d'un ensemble de plusieurs lignes raccordées électriquement en parallèle. Deux sections constituées chacune de trois lignes connectées en parallèle sont représentées sur la figure 1, mais généralement, le nombre de lignes par section et le nombre de sections sont plus importants. Chaque section 15, 16 est ensuite reliée au satellite 20 par deux conducteurs électriques de puissance 15a, 15b, 16a, 16b respectivement de polarité positive et négative, appelés aussi conducteurs électriques de transfert, dédiés au transfert de la puissance électrique engendrée par la section vers le satellite. Les conducteurs électriques de transfert 15a, 15b, 16a, 16b dédiés aux sections 15, 16 sont généralement aménagés sous les cellules solaires, sur la face arrière du support flexible 10 du générateur solaire. Un tel agencement est divulgué dans la demande de brevet US 2009301544. Comme les différentes sections sont aménagées les unes à côté des autres selon une même direction longitudinale du générateur solaire, les conducteurs électriques de puissance dédiés aux différentes sections passent sous les cellules solaires des sections voisines et transitent sous toute l'aile du générateur solaire 10 avant d'être raccordés au satellite 20.

Par exemple, sur la figure 1, les conducteurs électriques de transfert 15a, 15b de la section 15 passent sous les cellules solaires de la section 16.

Le problème est que dans le cas des générateurs solaires flexibles, la distance séparant les cellules solaires montées sur une face avant du support flexible et les conducteurs électriques de puissance montés sur une face arrière du support flexible est très faible, c'est-à-dire inférieure à un millimètre. Cette faible distance rend les générateurs solaires très sensibles aux impacts d'objets célestes, en particulier aux impacts de débris et de micrométéorites. En effet, les impacts, par exemple de débris ou de micrométéorites, peuvent percer localement une ou plusieurs cellules solaires ainsi que les isolants et les conducteurs de puissance situés sous la cellule solaire. L'impact crée une bulle de plasma qui, lorsque la tension électrique entre la cellule solaire impactée et le conducteur électrique est suffisante, par exemple supérieure à 50 Volts, peut engendrer un arc électrique 14 entre ladite cellule solaire impactée et le conducteur électrique placé sous cette cellule solaire. Si le courant électrique disponible à l'endroit de l'impact est suffisamment élevé, par exemple supérieur à 1,5 Ampère, l'arc électrique peut s'auto-entretenir, ce qui a pour effet de créer un court-circuit permanent dans une section du générateur solaire et une perte définitive d'une partie de la puissance électrique.

Pour protéger les cellules solaires contre des éventuels courants de décharge provenant des autres lignes de la section, chaque ligne est généralement munie, à son extrémité à polarité positive, d'une diode de blocage 17 permettant d'isoler les lignes entre elles et de limiter l'intensité du courant électrique dans chaque ligne à une valeur inférieure à 1,5 Ampère. Cependant ces diodes de blocage étant localisées sur le support flexible, au plus près des cellules solaires, elles protègent contre les arcs électriques engendrés entre des cellules solaires de lignes voisines mais ne protègent pas des arcs électriques engendrés entre les cellules solaires et les conducteurs électriques de transfert, en particulier les conducteurs électriques de transfert ayant une polarité positive, qui cheminent sous les cellules solaires et qui sont connectés en sortie d'une section du générateur solaire. Or à l'endroit de l'impact, la tension d'un conducteur électrique de transfert ayant une polarité positive peut être très supérieure à la tension de la cellule impactée, par exemple pour une ligne comportant 50 cellules solaires connectées en série, la tension d'un conducteur électrique de transfert ayant une polarité positive peut atteindre 100 Volts alors que la tension de l'extrémité à polarité négative de la première cellule d'une ligne est égale à zéro Volt. En outre, l'intensité du courant électrique circulant dans un conducteur électrique de transfert connecté en sortie d'une section est important, généralement très supérieur à 1,5 Ampère. Lorsqu'une micrométéorite traverse le générateur solaire et fait un trou dans une cellule solaire ainsi que dans l'isolant entre la cellule solaire et un conducteur électrique de transfert à polarité positive situé sous la cellule solaire, un arc électrique se crée et s'auto-entretient entre le conducteur électrique de puissance et la cellule solaire impactée. Un court-circuit est alors engendré entre la cellule impactée et le conducteur électrique de transfert 15a à polarité positive qui transite sous ladite cellule impactée. Un courant I d'arc électrique circule alors du conducteur électrique de transfert 15a à polarité positive vers un conducteur électrique de transfert 16b à polarité négative relié à l'extrémité négative de la ligne de cellules solaires dans laquelle l'impact a eu lieu. Les conducteurs électriques de transfert à polarité négative étant tous reliés entre eux dans le satellite 20, le courant I d'arc électrique retourne en sens inverse, par un conducteur électrique de transfert à polarité négative, dans le circuit électrique de la section 15 qui transite sous la cellule impactée. Ladite section 15 est alors en court-circuit et ne peut plus fournir de puissance au générateur solaire. Cette perte de puissance correspondant à la perte d'une section 15 complète du générateur solaire, est préjudiciable pour l'alimentation électrique des équipements embarqués sur le satellite.

Pour éviter que des arcs électriques se créent entre une cellule solaire et un conducteur électrique de transfert, il est possible de faire cheminer les conducteurs de transfert sur les bords du générateur solaire au lieu de les faire cheminer sur la face arrière, sous les cellules solaires. Cependant, les conducteurs électriques de transfert assurent également un rôle de blindage de la face arrière du générateur solaire contre les radiations, notamment des flux d'électrons et des flux de protons, qui dégradent les performances électriques des cellules solaires avec pour effet une réduction de la puissance électrique disponible. Par conséquent, si les conducteurs électriques de transfert sont déplacés sur les bords du générateur solaire, ils ne peuvent plus assurer le rôle de blindage et il est alors nécessaire d'ajouter un dispositif de blindage spécifique pour protéger la face arrière du générateur solaire, ce qui augmente la masse du générateur solaire.

Un but de l'invention est de remédier aux inconvénients des générateurs solaires flexibles connus et de réaliser un générateur solaire flexible comportant une protection électrique contre des impacts d'objets célestes, en particulier de débris et de micrométéorites, qui permette de limiter l'intensité du courant électrique entre les cellules solaires et des conducteurs électriques de transfert situés sous les cellules solaires sans pénaliser la puissance électrique engendrée par le générateur solaire, d'améliorer la tenue du générateur solaire et d'éviter la perte de puissance lors de la création d'un arc électrique permanent entre une cellule solaire trouée par un impact et un conducteur électrique de transfert cheminant sous la cellule solaire impactée.

Un autre but de l'invention est de réaliser un générateur solaire flexible comportant une protection électrique contre des impacts d'objets célestes, permettant en outre d'assurer le blindage de la face arrière du générateur solaire sans augmenter la masse, ni l'encombrement, du générateur solaire, par rapport aux générateurs solaires flexibles connus.

Pour cela, l'invention concerne un générateur solaire destiné à être fixé sur un engin spatial, le générateur solaire comportant un support flexible s'étendant selon un axe de déploiement longitudinal Y et ayant une extrémité proximale destinée à être reliée à l'engin spatial et une extrémité distale opposée à l'extrémité proximale, un réseau de cellules solaires aménagé sur une face avant du support flexible et des diodes de blocage. Les cellules solaires sont aménagées selon différentes lignes transversales espacées les unes des autres et électriquement indépendantes les unes des autres, les cellules solaires situées dans une même ligne transversale étant connectées électriquement en série, chaque ligne transversale comportant deux extrémités opposées, respectivement de polarité positive et de polarité négative. Le support flexible est constitué d'un substrat multicouche équipé de conducteurs électriques de transfert. L'extrémité de polarité positive de chaque ligne transversale est individuellement et directement reliée à un conducteur électrique de transfert dédié, les conducteurs électriques de transfert dédiés aux différentes lignes transversales étant indépendants les uns des autres, et chaque conducteur électrique de transfert relié à l'extrémité de polarité positive d'une ligne transversale comporte une extrémité proximale connectée à une diode de blocage localisée à l'extrémité proximale du générateur solaire, en dehors du réseau de cellules solaires.

Selon l'invention, le générateur solaire comporte un dispositif de conditionnement de puissance localisé à l'extérieur du support flexible et destiné à gérer l'énergie électrique délivrée par toutes les lignes transversales, le dispositif de conditionnement de puissance étant connecté à tous les conducteurs électriques de transfert, le dispositif de conditionnement de puissance comportant des moyens de connexion électrique aptes à connecter, en parallèle, plusieurs conducteurs électriques de transfert respectivement reliés aux extrémités de polarité positive de différentes lignes transversales correspondantes, pour former différentes sections de cellules solaires.

Avantageusement, le substrat multicouche comporte au moins deux couches d'isolant électrique localisées entre les conducteurs électriques de transfert et les cellules solaires collées sur la face avant du support flexible, les conducteurs électriques de transfert pouvant être aménagés sur une face arrière du support flexible.

Alternativement, le substrat multicouche peut comporter au moins deux couches d'isolant électrique et un circuit imprimé flexible comportant au moins une couche de pistes conductrices gravées prise en sandwich entre les deux couches d'isolant électrique, les conducteurs électriques de transfert étant constitués par les pistes conductrices gravées.

Alternativement, le substrat multicouche peut comporter trois couches d'isolant électrique et un circuit imprimé flexible comportant deux couches empilées munies de pistes conductrices gravées, chaque couche de pistes conductrices gravées étant respectivement prise en sandwich entre deux couches d'isolant électrique du support flexible, les conducteurs électriques de transfert étant constitués par les pistes conductrices gravées.

Avantageusement, les pistes conductrices gravées situées dans les deux couches empilées, peuvent être disposées en quinconce les unes par rapport aux autres.

Avantageusement, les pistes conductrices gravées situées dans les deux couches empilées, peuvent se recouvrir partiellement entre elles.

Avantageusement, les diodes de blocage peuvent être localisées sur le support flexible, à l'extrémité proximale du générateur solaire, dans une zone vierge exempte de cellules solaires.

Alternativement, le générateur solaire peut comporter en outre une interface mécanique à laquelle est fixé le support flexible, et les diodes de blocage peuvent être localisées sur l'interface mécanique, en dehors du support flexible.

Avantageusement, les diodes de blocage peuvent être disposées dans le dispositif de conditionnement de puissance, les moyens de connexion électrique étant connectés en sortie des diodes de blocage.

L'invention concerne aussi un engin spatial et un satellite comportant au moins un tel générateur solaire.

D'autres particularités et avantages de l'invention apparaîtront clairement dans la suite de la description donnée à titre d'exemple purement illustratif et non limitatif, en référence aux dessins schématiques annexés qui représentent :
- figure 1 : un schéma d'un exemple de câblage électrique des cellules solaires d'un générateur solaire, selon l'art antérieur ;
- figure 2 : un schéma illustrant un satellite muni d'un générateur solaire flexible, en position déployée, selon l'invention ;
- figure 3 : un schéma d'un exemple de câblage électrique des cellules solaires d'un générateur solaire, les diodes de blocages étant montées sur le support flexible, selon un premier mode de réalisation de l'invention ;
- figure 4 : un schéma d'une variante du câblage électrique des cellules solaires d'un générateur solaire, les diodes de blocage étant montées en dehors du support flexible, selon un deuxième mode de réalisation de l'invention ;
- figure 5 : un schéma en coupe transversale, d'un exemple de support flexible constitué d'un substrat multicouche comportant un circuit imprimé monocouche intégré entre deux couches d'isolant, selon l'invention ;
- figures 6a et 6b : deux schémas en coupe transversale, respectivement a) sans recouvrement des pistes, b) avec recouvrement des pistes, d'un exemple de support flexible constitué d'un substrat multicouche comportant un circuit imprimé muni de deux couches de pistes conductrices, gravées, chaque couche de pistes gravées étant prise en sandwich entre deux couches d'isolant, selon l'invention.

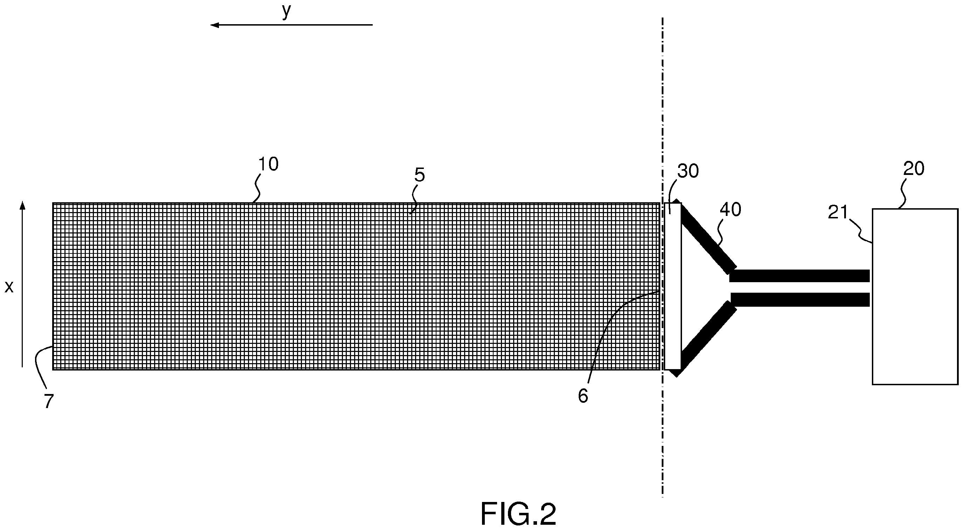

Généralement, un engin spatial, par exemple un satellite, comporte des ailes de générateur solaire destinés à fournir la puissance électrique nécessaire au fonctionnement des équipements montés sur le satellite. Le nombre d'ailes de générateur solaire dépend de la mission à remplir par l'engin spatial. Souvent, deux ailes de générateur solaire sont montées symétriquement de part et d'autre d'un engin spatial, sur deux flancs opposés de l'engin spatial. Pour optimiser l'illumination des ailes de générateur solaire, les générateurs solaires de chaque aile sont généralement fixés au bout d'un bras d'éloignement destiné à être fixé sur un flanc de l'engin spatial. Sur l'exemple de la figure 2, pour simplifier la description de l'invention, une seule aile de générateur solaire est représentée, mais bien entendu, le nombre d'ailes de générateur solaire peut être supérieur à un.

Selon l'invention, le générateur solaire s'étend selon un axe de déploiement longitudinal Y et a une extrémité proximale 6 destinée à être reliée à l'engin spatial et une extrémité distale 7 opposée à l'extrémité proximale. Le générateur solaire comporte un support flexible 10 planaire équipé de conducteurs électriques de transfert (120, 130) et un réseau de cellules solaires 5 aménagé sur une face avant du support flexible. Le support flexible peut être fixé directement sur un bras d'éloignement 40 ou alternativement, à une interface mécanique 30 montée à une première extrémité d'un bras d'éloignement 40, le bras d'éloignement 40 comportant une deuxième extrémité destinée à être fixée sur un flanc 21 de l'engin spatial 20. En position déployée, le support flexible 10 est constitué d'une surface plane s'étendant selon un plan XY, la direction Y étant orthogonale au flanc 21 de l'engin spatial 20 sur lequel le bras d'éloignement 40 est destiné à être fixé. Le réseau de cellules solaires 5 monté sur la face avant du support flexible 10 est localisé entre les extrémités proximale 6 et distale 7 du générateur solaire. Dans un mode de réalisation de l'invention, le réseau de cellules solaires peut ne pas s'étendre jusqu'à l'extrémité proximale pour laisser, sur la face avant du support flexible, au niveau de l'extrémité proximale, une zone vierge 8 exempte de cellules solaires.

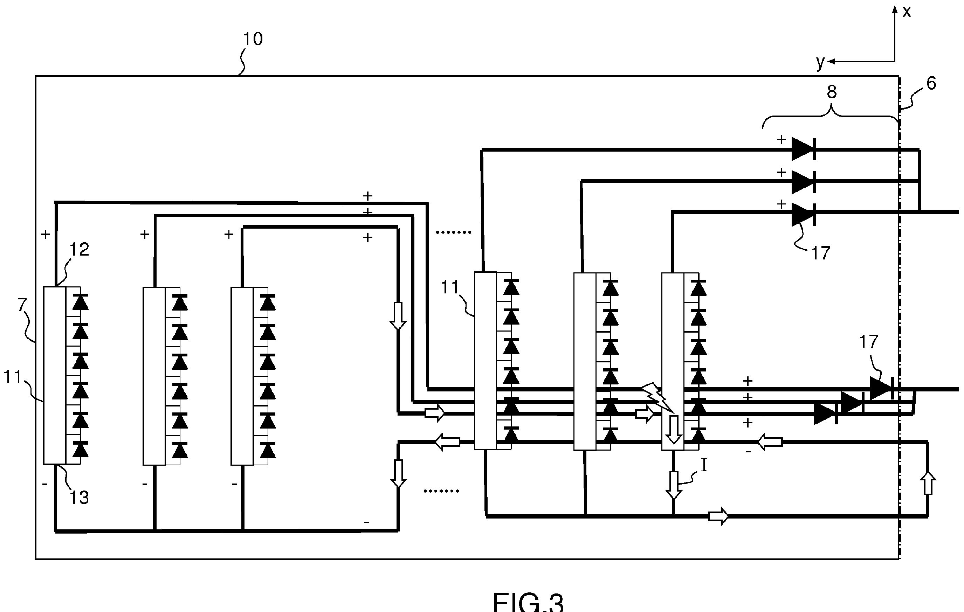

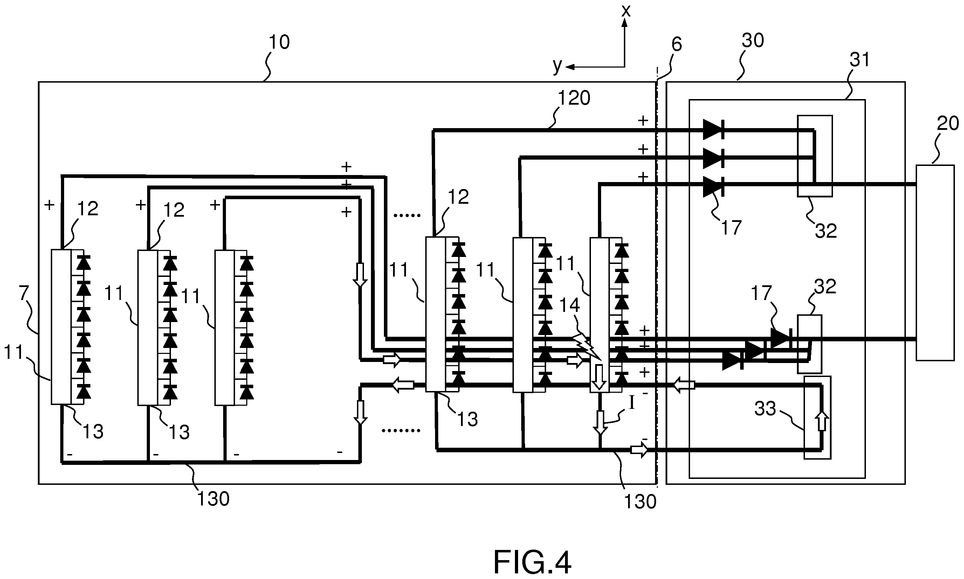

Les schémas des figures 3 et 4 illustrent des exemples de câblage électrique des cellules solaires, selon l'invention. Comme illustré dans ces exemples, les cellules solaires du réseau peuvent être aménagées selon différentes lignes 11 transversales, espacées les unes des autres. Les lignes 11 de cellules solaires peuvent être parallèles entre elles et à la direction X, mais ce n'est pas obligatoire. Les cellules solaires situées sur une même ligne 11 du générateur solaire sont connectées électriquement en série, les différentes lignes de cellules solaires étant électriquement indépendantes les unes des autres et comportant deux extrémités 12, 13 à polarité respectivement positive et négative. Les deux extrémités de chaque ligne 11 de cellules solaires sont respectivement reliées à deux conducteurs électriques de transfert 120, 130 dédiés, destinés à transmettre l'énergie, de polarité respectivement positive et négative, engendrée par la ligne 11 de cellules solaires jusqu'à un dispositif de conditionnement de puissance 31 localisé à l'extérieur du support flexible, par exemple sur l'interface mécanique 30 comme représenté sur la figure 4, ou dans l'engin spatial 20. Les conducteurs électriques de transfert 120, 130 sont aménagés longitudinalement, sous les lignes transversales 11. Les conducteurs électriques de transfert 120, 130 cheminent donc transversalement par rapport aux lignes 11 de cellules solaires et passent successivement sous les différentes lignes 11 de cellules solaires du réseau aménagées sur la face avant du support flexible, entre la ligne 11 considérée et l'extrémité proximale 6. L'extrémité 12 de polarité positive de chaque ligne 11 transversale est individuellement et directement reliée à un conducteur électrique de transfert 120 dédié. Les conducteurs électriques de transfert 120, 130 dédiés à chaque ligne 11 de cellules solaires sont directement reliés au dispositif de conditionnement de puissance, situé en dehors du support flexible 10. Chaque ligne 11 transversale est donc individuellement reliée au dispositif de conditionnement de puissance 31, ce qui permet de traiter la puissance électrique, engendrée par le générateur solaire, à l'extérieur du support flexible 10 et de limiter l'intensité des courants électriques circulant dans les conducteurs de transfert 120 à polarité positive, situés sur la face arrière du support flexible, puisque le courant électrique correspond alors à celui créé par une seule ligne du générateur solaire. Dans le dispositif de conditionnement de puissance 31, les conducteurs de transfert 120 à polarité positive, dédiés à chaque ligne transversale, sont connectés à une diode de blocage 17 respective, chaque diode de blocage étant dédiée à la protection d'une ligne transversale du générateur solaire contre des courants de décharge provenant des autres lignes transversales. Pour avoir de la redondance, il peut y avoir deux conducteurs électriques de transfert dédiés à chaque ligne de cellules solaires et une diode de blocage reliée aux deux conducteurs électriques de transfert correspondants. Les différentes diodes de blocage sont localisées à l'extrémité proximale 6 du générateur solaire, en dehors du réseau de cellules solaires. Par exemple, comme représenté sur la figure 3, les diodes de blocage 17 peuvent être localisées sur le support flexible 10, à l'extrémité proximale 6 du générateur solaire, dans la zone vierge 8 exempte de cellules solaires, sur la face avant ou arrière, ou alternativement, en dehors du support flexible, par exemple sur l'interface mécanique 30, comme représenté sur la figure 4, ou dans l'engin spatial 20. En sortie des diodes de blocage 17, le dispositif de conditionnement de puissance comporte des premiers et des seconds moyens de connexion 32, 33 aptes à regrouper les lignes 11 de cellules solaires en différentes sections, chaque section comportant plusieurs lignes de cellules solaires reliées en parallèle. Dans chaque section, les premiers moyens de connexions 32 connectent les conducteurs électriques de transfert de polarité positive dédiés aux lignes de la section. Les conducteurs électriques de transfert 130 de polarité négative, sont tous reliés entre eux par les seconds moyens de connexion 33, dans le dispositif de conditionnement de puissance 31.

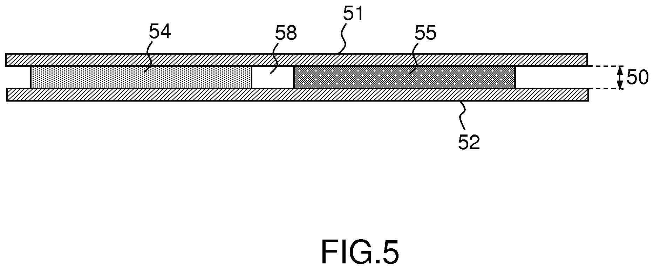

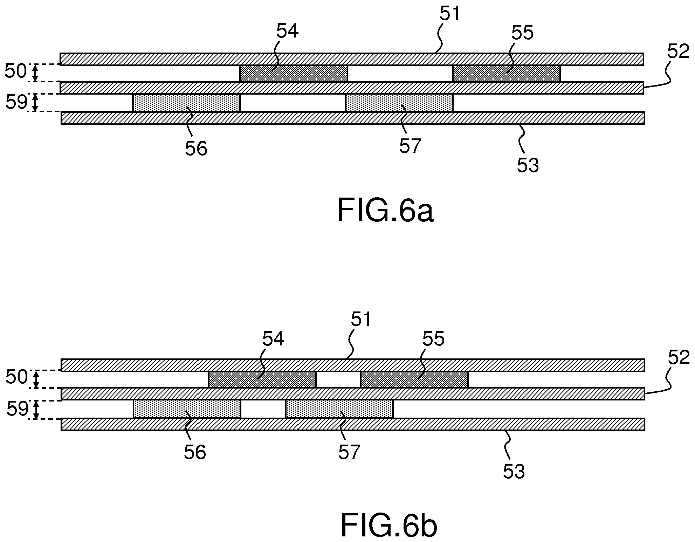

Le support flexible est constitué d'un substrat multicouche planaire comportant des conducteurs électriques de transfert et au moins deux couches d'isolant électrique, par exemple en Kapton, localisées entre les conducteurs électriques de transfert et les cellules solaires collées sur la face avant du support flexible. Les conducteurs électriques de transfert peuvent être constitués de câbles électriques aménagés sur la face arrière du support flexible 10. Alternativement, les conducteurs électriques de transfert peuvent être constitués par des pistes conductrices, par exemple en argent, gravées sur un circuit imprimé flexible, le circuit imprimé étant intégré dans le substrat multicouche du support flexible 10. Le circuit imprimé peut être monocouche comme représenté sur la figure 5, ou multicouche comme représenté sur les figures 6a et 6b. Lorsque le circuit imprimé est monocouche, la couche 50 de circuit imprimé est prise en sandwich entre deux couches d'isolant électrique 51 , 52 du support flexible et les différentes pistes 54, 55 de la couche 50 sont isolées entre elles par un espace 58. En raison de l'espace 58 entre les pistes 54, 55, cette configuration ne permet pas d'assurer un blindage complet de la face arrière du support flexible. Lorsque le circuit imprimé est multicouche, comme sur la figure 6a, les pistes 54, 55, 56, 57 du circuit imprimé peuvent être disposées en quinconce dans deux couches différentes 59, 50, respectivement inférieure et supérieure, empilées l'une au-dessus de l'autre, chaque couche 59, 50 de pistes gravées étant prise en sandwich entre deux couches d'isolant électrique 51, 52, 53 du support flexible. Dans cette configuration, comme sur la figure 6b, il peut y avoir un recouvrement partiel entre les pistes de la couche supérieure 50 du circuit imprimé et les pistes de la couche inférieure 59 du circuit imprimé. Cette configuration permet donc d'assurer un blindage complet de la face arrière du support flexible.

Les lignes 11 indépendantes entre elles, n'étant pas regroupées en sections sur le support flexible 10, chaque conducteur électrique de transfert 120 à polarité positive qui chemine sous les cellules solaires, transporte l'énergie électrique engendrée par une seule ligne de cellules solaires, jusqu'à l'interface mécanique 30. Tous les conducteurs électriques de transfert 120 à polarité positive, dédiés aux différentes lignes sont donc indépendants les uns des autres. Le courant électrique circulant dans les conducteurs électriques de transfert est donc faible, c'est-à-dire inférieur à 1,5 Ampère. Par conséquent, en cas d'impact, par exemple de débris ou de micrométéorite, sur une ligne 11 de cellules solaires, l'arc électrique 14 créé par l'impact va s'éteindre car le courant de décharge est limité à celui de la seule ligne 11 impactée, grâce à la diode de blocage 17 dédiée à la protection de cette ligne 11 impactée.

En outre, les diodes de blocage 17 étant localisées en dehors du réseau de cellules solaires, toute la surface du générateur solaire est protégée contre des éventuels courants de décharge provenant d'une ligne 11 quelconque. En présence d'un trou d'impact dans une ligne du générateur solaire, une seule ligne sera éventuellement en court-circuit et ne fournira plus de puissance, comme le montrent les flèches symbolisant le trajet du courant I de court-circuit sur les figures 3 et 4. La perte de puissance du générateur solaire, limitée à celle créée par une ligne 11, sera donc beaucoup plus faible que dans les générateurs solaires flexibles actuels.

En présence d'un trou d'impact sur deux conducteurs électriques superposés, isolés et de polarités différentes, sur la surface du générateur solaire, ainsi protégée, le courant est aussi limité en cas d'arc électrique entre le conducteur électrique de polarité positive et le conducteur électrique de polarité négative. Cette protection est effective contre les arcs électriques entre les cellules solaires et les conducteurs électriques, mais aussi entre des conducteurs électriques de polarités différentes.

L'interface mécanique 30 peut par exemple, être montée sur le bras d'éloignement 40 relié à l'engin spatial 20 comme illustré sur la figure 2, ou être directement montée sur l'engin spatial 20.

Les conducteurs électriques de transfert 120, 130, situés sur la face arrière du support flexible ou intégrés dans le substrat du support flexible, et cheminant transversalement par rapport aux lignes 11 de cellules solaires, assurent en outre une fonction de blindage de la face arrière du générateur solaire sans qu'il soit nécessaire d'ajouter un blindage spécifique additionnel. La masse et l'encombrement du générateur solaire sont ainsi optimisés.

Bien que l'invention ait été décrite en liaison avec des modes de réalisation particuliers, il est bien évident qu'elle n'y est nullement limitée et qu'elle comprend tous les équivalents techniques des moyens décrits ainsi que leurs combinaisons si celles-ci entrent dans le cadre de l'invention.

## Revendications

1. Générateur solaire destiné à être fixé sur un engin spatial, le générateur solaire comportant un support flexible (10) constitué d'un substrat multicouche équipé de conducteurs électriques de transfert, le support flexible (10) s'étendant selon un axe de déploiement longitudinal Y et ayant une extrémité proximale (6) destinée à être reliée à l'engin spatial et une extrémité distale (7) opposée à l'extrémité proximale, le générateur solaire comprenant un réseau de cellules solaires (5) aménagé sur une face avant du support flexible (10) et des diodes de blocage (17), les cellules solaires étant aménagées selon différentes lignes (11) transversales espacées les unes des autres et électriquement indépendantes les unes des autres, les cellules solaires situées dans une même ligne (11) transversale étant connectées électriquement en série, chaque ligne (11) transversale comportant deux extrémités opposées (12, 13), respectivement de polarité positive et de polarité négative, **caractérisé en ce que** l'extrémité (12) de polarité positive de chaque ligne (11) transversale est individuellement et directement reliée à un conducteur électrique de transfert (120) dédié, les conducteurs électriques de transfert (120) dédiés aux différentes lignes (11) transversales étant indépendants les uns des autres, et **en ce que** chaque conducteur électrique de transfert relié à l'extrémité (12) de polarité positive d'une ligne (11) transversale comporte une extrémité proximale connectée à une diode de blocage (17) localisée à l'extrémité proximale (6) du générateur solaire, en dehors du réseau de cellules solaires, le générateur solaire comprenant en outre un dispositif de conditionnement de puissance (31) localisé à l'extérieur du support flexible et destiné à gérer l'énergie électrique délivrée par toutes les lignes (11) transversales, le dispositif de conditionnement de puissance (31) étant connecté à tous les conducteurs électriques de transfert (120, 130), le dispositif de conditionnement de puissance comportant des moyens de connexion électrique (32, 33) aptes à connecter, en parallèle, plusieurs conducteurs électriques de transfert respectivement reliés aux extrémités (12) de polarité positive de différentes lignes (11) transversales correspondantes, pour former différentes sections de cellules solaires, chaque conducteur électrique de transfert relié à l'extrémité positive d'une ligne transversale d'une première section de cellules solaires cheminant sous les lignes transversales d'une autre section située entre la première section et l'extrémité proximale.

2. Générateur solaire selon la revendication 1, **caractérisé en ce que** le substrat multicouche comporte au moins deux couches d'isolant électrique localisées entre les conducteurs électriques de transfert et les cellules solaires collées sur la face avant du support flexible, les conducteurs électriques de transfert (120, 130) étant aménagés sur une face arrière du support flexible.

3. Générateur solaire selon la revendication 1, **caractérisé en ce que** le substrat multicouche comporte au moins deux couches d'isolant électrique (51, 52) et un circuit imprimé flexible comportant au moins une couche (50) de pistes conductrices gravées prise en sandwich entre les deux couches d'isolant électrique, les conducteurs électriques de transfert (120, 130) étant constitués par les pistes conductrices gravées (54, 55).

4. Générateur solaire selon la revendication 1, **caractérisé en ce que** le substrat multicouche comporte trois couches d'isolant électrique (51, 52, 53) et un circuit imprimé flexible comportant deux couches (50, 59) empilées munies de pistes conductrices gravées (54, 55, 56, 57), chaque couche de pistes conductrices gravées étant respectivement prise en sandwich entre deux couches d'isolant électrique du support flexible, les conducteurs électriques de transfert (120, 130) étant constitués par les pistes conductrices gravées (54, 55, 56, 57).

5. Générateur solaire selon la revendication 4, **caractérisé en ce que** les pistes conductrices gravées (54, 55, 56, 57) situées dans les deux couches (50, 59) empilées, sont disposées en quinconce les unes par rapport aux autres.

6. Générateur solaire selon la revendication 5, **caractérisé en ce que** les pistes conductrices gravées situées dans les deux couches empilées, se recouvrent partiellement entre elles.

7. Générateur solaire selon l'une des revendications 1 à 6, **caractérisé en ce que** les diodes de blocage (17) sont localisées sur le support flexible (10), à l'extrémité proximale du générateur solaire, dans une zone vierge (8) exempte de cellules solaires.

8. Générateur solaire selon l'une des revendications 1 à 6, **caractérisé en ce qu'**il comporte en outre une interface mécanique (30) à laquelle est fixé le support flexible (10), et **en ce que** les diodes de blocage (17) sont localisées sur l'interface mécanique (30), en dehors du support flexible (10).

9. Générateur solaire selon la revendication 8, **caractérisé en ce que** les diodes de blocage (17) sont disposées dans le dispositif de conditionnement de puissance (31), les moyens de connexion électrique (32) étant connectés en sortie des diodes de blocage (17).

10. Engin spatial **caractérisé en ce qu'**il comporte au moins un générateur solaire selon l'une des revendications 1 à 9.

11. Engin spatial selon la revendication 10, **caractérisé en ce qu'**il est constitué par un satellite.

## Patentansprüche

1. Solargenerator, dazu bestimmt, an einem Raumfahrzeug befestigt zu werden, wobei der Solargenerator eine flexible Halterung (10) beinhaltet, welche aus einem mehrschichtigen Substrat gebildet ist, welches mit elektrischen Übertragungsleitern ausgerüstet ist, wobei die flexible Halterung (10) sich entlang einer Längsentfaltungsachse Y erstreckt und ein proximales Ende (6) besitzt, dazu bestimmt, mit dem Raumfahrzeug verbunden zu werden und ein distales Ende (7), welches dem proximalen Ende abgewandt ist, wobei der Solargenerator ein Netzwerk von Solarzellen (5), welches an einer Vorderseite der flexiblen Halterung (10) angeordnet ist und Sperrdioden (17) beinhaltet, wobei die Solarzellen in unterschiedlichen Querreihen (11) angeordnet sind, welche voneinander entfernt und elektrisch voneinander unabhängig sind, wobei die in einer selben Querreihe (11) befindlichen Solarzellen elektrisch in Reihe angeschlossen sind, wobei jede Querreihe (11) zwei voneinander abgewandte Enden (12, 13) beinhaltet, welche jeweils eine positive und eine negative Polarität besitzen, **dadurch gekennzeichnet, dass** das Ende (12) mit positiver Polarität einer jeden Querreihe (11) individuell und direkt mit einem zugewiesenen elektrischen Übertragungsleiter (120) verbunden ist, wobei die den unterschiedlichen Querreihen (11) zugewiesenen elektrischen Übertragungsleiter (120) voneinander unabhängig sind, und dadurch, dass jeder elektrische Übertragungsleiter, der mit dem Ende (12) mit positiver Polarität einer Querreihe (11) verbunden ist, ein proximales Ende beinhaltet, welches an eine am proximalen Ende (6) des Solargenerators befindliche Sperrdiode (17) angeschossen ist, außerhalb des Netzwerks von Solarzellen, wobei der Solargenerator zudem eine Leistungskonditionierungsvorrichtung (31) beinhaltet, welche außerhalb der flexiblen Halterung befindlich und dazu bestimmt ist, die von allen Querreihen (11) abgegebene elektrische Energie zu verwalten, wobei die Leistungskonditionierungsvorrichtung (31) an alle elektrischen Übertragungsleiter (120, 130) angeschlossen ist, wobei die Leistungskonditionierungsvorrichtung Mittel zum elektrischen Anschluss (32, 33) beinhaltet, welche in der Lage sind, parallel mehrere jeweils mit den Enden (12) mit positiver Polarität verbundene elektrische Übertragungsleiter unterschiedlicher entsprechender Querreihen (11) zu verbinden, um unterschiedliche Solarzellen-Abschnitte zu bilden, wobei jeder mit dem Ende mit positiver Polarität einer Querreihe des ersten Solarzellen-Abschnitts verbundene elektrische Übertragungsleiter unterhalb der Querreihen eines anderen Abschnitts verläuft, welcher sich zwischen dem ersten Abschnitt und dem proximalen Ende befindet.

2. Solargenerator nach Anspruch 1, **dadurch gekennzeichnet, dass** das mehrschichtige Substrat mindestens zwei elektrische Isolatorschichten beinhaltet, welche zwischen den elektrischen Übertragungsleitern und den auf der Vorderseite der flexiblen Halterung aufgeklebten Solarzellen befindlich sind, wobei die elektrischen Übertragungsleiter (120, 130) auf einer Hinterseite der flexiblen Halterung angeordnet sind.

3. Solargenerator nach Anspruch 1, **dadurch gekennzeichnet, dass** das mehrschichtige Substrat mindestens zwei elektrische Isolatorschichten (51, 52) und eine flexible, gedruckte Schaltung beinhaltet, welche mindestens eine Schicht (50) gravierter, leitender Spuren beinhaltet, welche sandwichartig zwischen den beiden elektrischen Isolatorschichten befindlich ist, wobei die elektrischen Übertragungsleiter (120, 130) aus den gravierten, leitenden Spuren (54, 55) gebildet sind.

4. Solargenerator nach Anspruch 1, **dadurch gekennzeichnet, dass** das mehrschichtige Substrat drei elektrische Isolatorschichten (51, 52, 53) und eine flexible, gedruckte Schaltung beinhaltet, welche zwei gestapelte, mit gravierten, leitenden Spuren (54, 55, 56, 57) versehene Schichten (50, 59) beinhaltet, wobei jede Schicht mit gravierten, leitenden Spuren jeweils sandwichartig zwischen zwei elektrischen Isolatorschichten der flexiblen Halterung befindlich ist, wobei die elektrischen Übertragungsleiter (120, 130) aus den gravierten, leitenden Spuren (54, 55, 56, 57) gebildet sind.

5. Solargenerator nach Anspruch 4, **dadurch gekennzeichnet, dass** die gravierten, leitenden Spuren (54, 55, 56, 57), welche sich in den beiden gestapelten Schichten (50, 59) befinden, im Zickzack zueinander angeordnet sind.

6. Solargenerator nach Anspruch 5, **dadurch gekennzeichnet, dass** die gravierten, leitenden Spuren, welche sich in den beiden gestapelten Schichten befinden, einander teilweise überlappen.

7. Solargenerator nach einem der Ansprüche 1 bis 6, **dadurch gekennzeichnet, dass** die Sperrdioden (17) auf der flexiblen Halterung (10) befindlich sind, am proximalen Ende des Solargenerators, in einem leeren Bereich (8), welcher frei von Solarzellen ist.

8. Solargenerator nach einem der Ansprüche 1 bis 6, **dadurch gekennzeichnet, dass** er zudem eine mechanische Schnittstelle (30) beinhaltet, an welcher die flexible Halterung (10) befestigt ist, und dadurch, dass die Sperrdioden (17) an der mechanischen Schnittstelle (30), außerhalb der flexiblen Halterung (10), befindlich sind.

9. Solargenerator nach Anspruch 8, **dadurch gekennzeichnet, dass** die Sperrdioden (17) in der Leistungskonditionierungsvorrichtung (31) angeordnet sind, wobei die Mittel zum elektrischen Anschluss (32) am Ausgang der Sperrdioden (17) angeschlossen sind.

10. Raumfahrzeug, **dadurch gekennzeichnet, dass** es mindestens einen Solargenerator nach einem der Ansprüche 1 bis 9 beinhaltet.

11. Raumfahrzeug nach Anspruch 10, **dadurch gekennzeichnet, dass** es durch einen Satelliten gebildet ist.

## Claims

1. Solar generator intended to be fixed onto a spacecraft, in which the solar generator comprises a flexible support (10) consisting of a multilayer substrate equipped with electrical transfer conductors, the flexible support (10) extending along a longitudinal deployment axis Y and having a proximal end (6) intended to be linked to the spacecraft and a distal end (7) opposite the proximal end, the solar generator comprising an array of solar cells (5) formed on a front face of the flexible support (10) and blocking diodes (17), the solar cells being formed along different transverse strings (11) spaced apart from one another and electrically independent of one another, the solar cells situated in a same transverse string (11) being electrically connected in series, each transverse string (11) comprising two opposite ends (12, 13), respectively of positive polarity and of negative polarity, **characterized in that** the positive polarity end (12) of each transverse string (11) is individually and directly linked to a dedicated electrical transfer conductor (120), the electrical transfer conductors (120) dedicated to the different transverse strings (11) being independent of one another, and **in that** each electrical transfer conductor linked to the positive polarity end (12) of a transverse string (11) comprises a proximal end connected to a blocking diode (17) located at the proximal end (6) of the solar generator, outside of the array of solar cells, the solar generator further comprising a power conditioning device (31) located outside the flexible support and intended to manage the electrical energy delivered by all the transverse strings (11), the power conditioning device (31) being connected to all the electrical transfer conductors (120, 130), the power conditioning device comprising electrical connection means (32, 33) suitable for connecting, in parallel, a number of electrical transfer conductors respectively linked to the positive polarity ends (12) of different corresponding transverse strings (11), to form different solar cell sections, each electrical transfer conductor linked to the positive polarity end of a transverse string of a first section of solar cells being routed under the transverse strings of another section situated between the first section and the proximal end.

2. Solar generator according to Claim 1, **characterized in that** the multilayer substrate comprises at least two layers of electrical insulating material located between the electrical transfer conductors and the solar cells glued onto the front face of the flexible support, the electrical transfer conductors (120, 130) being formed on a rear face of the flexible support.

3. Solar generator according to Claim 1, **characterized in that** the multilayer substrate comprises at least two layers of electrical insulating material (51, 52) and a flexible printed circuit comprising at least one layer (50) of etched conductive tracks sandwiched between the two layers of electrical insulating material, the electrical transfer conductors (120, 130) consisting of the etched conductive tracks (54, 55).

4. Solar generator according to Claim 1, **characterized in that** the multilayer substrate comprises three layers of electrical insulating material (51, 52, 53) and a flexible printed circuit comprising two stacked layers (50, 59) provided with etched conductive tracks (54, 55, 56, 57), each layer of etched conductive tracks being respectively sandwiched between two layers of electrical insulating material of the flexible support, the electrical transfer conductors (120, 130) consisting of the etched conductive tracks (54, 55, 56, 57).

5. Solar generator according to Claim 4, in which the etched conductive tracks (54, 55, 56, 57) situated in the two stacked layers (50, 59) are arranged staggered relative to one another.

6. Solar generator according to Claim 5, **characterized in that** the etched conductive tracks situated in the two stacked layers partially overlap one another.

7. Solar generator according to one of Claims 1 to 6, **characterized in that** the blocking diodes (17) are located on the flexible support (10), at the proximal end of the solar generator, in a clear zone (8) free of solar cells.

8. Solar generator according to one of Claims 1 to 6, **characterized in that** it further comprises a mechanical interface (30) to which the flexible support (10) is fixed, and **in that** the blocking diodes (17) are located on the mechanical interface (30), outside of the flexible support (10).

9. Solar generator according to Claim 8, **characterized in that** the blocking diodes (17) are located in the power conditioning device (31), the electrical connection means (32) being connected at the output of the blocking diodes (17).

10. Spacecraft, **characterized in that** it comprises at least one solar generator according to one of claims 1 to 9.

11. Spacecraft according to Claim 10, **characterized in that** it consists of a satellite.
